Europäisches Patentamt

European Patent Office

Office européen des brevets

(11) Numéro de publication: **0 318 921 B1**

# FASCICULE DE BREVET EUROPEEN

(45) Date de publication de fascicule du brevet: **30.12.92**

(51) Int. Cl.⁵: **H01L 39/14**, H01L 39/24, H01B 12/04

(21) Numéro de dépôt: **88119886.5**

(22) Date de dépôt: **29.11.88**

(54) **Brin composite supraconducteur à haute température critique et procédé de fabrication.**

(30) Priorité: **02.12.87 FR 8716720**

(43) Date de publication de la demande:
**07.06.89 Bulletin 89/23**

(45) Mention de la délivrance du brevet:
**30.12.92 Bulletin 92/53**

(84) Etats contractants désignés:
**AT BE CH DE ES FR GB GR IT LI LU NL SE**

(56) Documents cités:

**JOURNAL OF APPLIED PHYSICS LETTERS, vol. 51, no. 3, 20 juillet 1987, pages 203-204, American Insitute of Physics, Woodbury, New York, US; S. JIN et al.: "High Tc super-conductors - composite wire fabrication"**

**JAPANESE JOURNAL OF APPLIED PHYSICS, vol. 26, no. 10, octobre 1987, pages 1653-1656, Tokyo, JP; O. KOHNO et al.: "Critical current density of Y-Ba-Cu oxide wires"**

**ADVANCED CERAMIC MATERIALS - CERAMIC SUPERCONDUCTORS, vol. 2, no. 3B,, 20**

**juillet 1987, pages 388-400, American Ceramic Society Publication, Westerville, Ohio, US; R.W. McCALLUM et al.: "Problems in the production of YBa2Cu3Ox superconducting wire"**

(73) Titulaire: **GEC ALSTHOM SA**
**38, avenue Kléber**
**F-75116 Paris(FR)**

(72) Inventeur: **Legat, Denis**
**4, Square de la Beauce**
**F-91090 Lisses(FR)**
Inventeur: **Dubots, Patrick**
**1, Chemin de Gaillarbois**
**F-78640 Neauphle le Chateau(FR)**

(74) Mandataire: **Weinmiller, Jürgen et al**
**Lennéstrasse 9 Postfach 24**
**W-8133 Feldafing(DE)**

# Description

La présente invention concerne un procédé de fabrication d'un brin composite supraconducteur à haute température critique.

Un brin supraconducteur est généralement constitué :
- d'un ou plusieurs filaments (jusqu'à plusieurs centaines de milliers) du matériau supraconducteur,
- d'une matrice en métal "normal", dans laquelle sont noyés les filaments supraconducteurs. Cette matrice généralement en cuivre ou en aluminium assure plusieurs fonctions :
- la stabilisation du supraconducteur : pour cela, le matériau de la matrice doit avoir des conductibilités thermique et électrique d'autant plus élevées que la taille des filaments est élevée,
- la tenue mécanique du brin lorsque celui-ci est soumis aux efforts électromagnétiques.

La mise en forme de fil des nouveaux matériaux supraconducteurs à haute température critique pose des problèmes spécifiques. En effet, il s'agit d'oxydes, par exemple $Y\,Ba_2Cu_3O_{7-y}$, qui sont indéformables. Leur mise en forme n'est possible qu'à l'état pulvérulent, comme c'est le cas pour d'autres supraconducteurs, à l'exemple des composé du type "Phases de Chevrel" décrits dans le brevet français n° 2 553 565 du 18 octobre 1983.

Par ailleurs les propriétés supraconductrices de ces oxydes sont très sensibles à leur environnement en oxygène : en particulier, le frittage de la poudre, nécessaire pour assurer la continuité électrique entre les grains, doit être réalisé en atmosphère oxydante. Si la poudre est enfermée dans une gaine métallique, il n'est alors pas possible d'assurer l'environnement en oxygène nécessaire.

En outre, il n'est pas possible d'utiliser le cuivre comme matériau de matrice car, à l'état d'oxyde, il réagit avec l'oxyde supraconducteur pour former des phases plus stables non supraconductrices. Par exemple, dans le cas de $Y\,Ba_2Cu_3O_{7-y}$, les produits de décomposition sont $Y_2BaCuO_5$ et $BaCu_2O$.
Deux solutions à ces problèmes ont déjà été proposées.
Dans le premier cas, il s'agit de réaliser un filament d'oxyde supraconducteur dans une matrice de cuivre ou d'alliages cuivreux (CuNi par exemple), puis, avant le traitement thermique de frittage, de dissoudre la matrice de cuivre afin que le ou les filaments d'oxydes soient en présence de l'oxygène.
La dissolution a, jusqu'à maintenant, été faite pour rechercher la capacité maximale de transport du courant du filament supraconducteur. Ce procédé, testé sur de courtes longueurs de filament, ne pourrait pas être industrialisé. D'une part en raison de l'absence de cuivre, les fonctions de stabilisation thermodynamique et de maintien mécanique du filament ne sont plus assurées. D'autre part la réalisation industrielle suppose une dissolution du cuivre sur de grandes longueurs, ce qui pose le problème du maintien de l'intégrité mécanique du matériau supraconducteur qui n'est pas encore fritté.

Dans le second cas, plus largement étudié (voir Appl.Phys.Lett. 51(3) 1987, p.203), la matrice utilisée est en argent. Outre son coût élevé, l'argent n'a pas une bonne tenue mécanique; de plus, il semble que l'argent dégrade les propriétés supraconductrices du filament. Cette solution ne devrait donc pas connaître un développement industriel important.

La présente invention a pour but de réaliser un brin composite supraconducteur à haute température critique dont la structure soit telle qu'on puisse réaliser sa fabrication de manière industrielle.

Ce but est atteint selon l'invention par le procédé tel que défini dans la revendication 1.

En ce qui concerne des mesures préférées de ce procédé, référence est faite aux revendications secondaires.

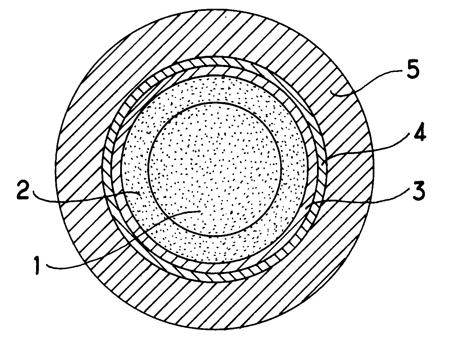

La présente invention sera décrite ci-après plus en détail à l'aide d'un mode de réalisation donné à titre illustratif mais nullement limitatif. Dans le dessin annexé la figure unique montre très schématiquement en coupe transversale un brin réalisé selon l'invention.

Le brin élémentaire visible dans la figure comprend un filament central à base de poudre frittée d'oxyde supraconducteur $YBa_2Cu_3O_{7-y}$ entouré de plusieurs gaines. Tout d'abord on forme une couronne 2 à base de poudre d'oxyde de baryum chimiquement inerte vis-à-vis de l'oxyde supraconducteur. Il peut s'agir de BaO ou de $BaO_2$. Cet oxyde est stable jusqu'à des températures de l'ordre de 800°C. Sa fonction est de maintenir autour du filament 1 une pression d'oxygène suffisante quelle que soit la température, et notamment au moment du frittage de la poudre supraconductrice.

La couronne interne 2 est entourée d'une gaine en aluminium 3 qui, au contact de la couronne 2, forme une pellicule mince d'alumine, très peu perméable à l'oxygène qui se trouve donc confiné autour du filament 1.

Une couronne extérieure de cuivre 5 est destinée à assurer la stabilisation thermodynamique du brin, et, entre cette couronne et la gaine d'aluminium 3, est prévue une gaine en niobium 4 assurant le rôle de barrière anti-diffusion du cuivre vers le filament supraconducteur 1.

Afin de réaliser le brin monofilamentaire qui vient d'être décrit, on opère de la façon suivante :

On réalise un bâtonnet à partir de poudre d'oxyde supraconducteur YBa$_2$Cu$_3$O$_{7-y}$, par compactage isostatique,

on réalise un tube à partir de poudre d'oxyde de baryum par compactage isostatique,

on monte ensuite un ensemble constitué du bâtonnet et du tube précédent, d'un tube d'aluminium, d'un tube de niobium et d'un tube de cuivre.

A titre d'exemple :

- le bâtonnet présente un diamètre de 5 mm
- le tube d'oxyde présente une épaisseur de 1 mm
- le tube d'aluminium présente une épaisseur de 1 mm
- le tube de niobium présente une épaisseur de 0,5 mm

On procède ensuite à l'étirage et au tréfilage selon les procédés connus par exemple comme décrit dans le brevet français n° 2 543 741.

On procède enfin au chauffage de la poudre supraconductrice à une température de l'ordre de 900° C à 950° C. Le brin filamentaire obtenu présente un diamètre de l'ordre de 0,3 mm.

Il peut être utilisé pour réaliser un brin multifilamentaire par simple empilement d'un grand nombre de brins monofilamentaires.

Bien entendu, l'invention n'est pas limitée au mode de réalisation qui vient d'être décrit. Tout élément mentionné peut être remplacé par un élément équivalent. Ainsi l'oxyde de la couronne 2 peut éventuellement au cours du frittage se décomposer en un oxyde de degré d'oxydation inférieur, l'oxygène libéré permettant de stabiliser l'oxyde supraconducteur. Ainsi on peut utiliser, outre l'alumine, un oxyde de plomb, tel que PbO$_2$, PbO, Pb$_3$O$_4$, un oxyde d'argent tel que Ag$_2$O ou Ag$_2$O$_2$, la magnésie, la zircone, la zircone yttriée, l'oxyde de calcium CaO$_2$, un oxyde du type Y$_2$-BaCuO$_3$. Cet oxyde peut être utilisé seul ou en mélange avec au moins un autre : on peut mélanger par exemple l'oxyde de baryum avec la magnésie ou même avec un oxyde supraconducteur.

L'utilisation d'oxydes à basse température de décomposition, du type oxydes de plomb ou oxyde d'argent, a l'avantage de former, après décomposition, une gaine métallique pour assurer la liaison électrique entre le supraconducteur et la couronne extérieure.

On met en oeuvre de préférence une gaine 3 en aluminium qui est en matériau très ductile, mais on peut le remplacer par l'acier inoxydable, ou un alliage de cuivre et d'aluminium dont la teneur en cuivre est par exemple comprise entre 4 et 9 % en poids d'aluminium. Le niobium de la gaine 4 peut être remplacé par le tantale, le vanadium.

D'autres procédés peuvent être mis en oeuvre pour la réalisation du bâtonnet et du tube d'oxyde qui l'entoure.

Mais dans tous les cas, l'agencement selon l'invention assure l'imperméabilité vis-à-vis de l'oxygène du matériau supraconducteur : il permet de le protéger d'une contamination par la couronne extérieure, de maintenir une pression partielle d'oxygène suffisante et de fournir éventuellement de l'oxygène.

**Revendications**

1. Procédé de fabrication d'un brin composite supraconducteur à haute température critique comprenant un filament de poudre d'oxyde supraconducteur frittée (1) et une couronne extérieure en cuivre (5), caractérisé par le fait que

   - on réalise un batonnet par compactage isostatique de ladite poudre d'oxyde supraconducteur, pour former ledit filament (1),
   - on réalise un tube par compactage isostatique d'une poudre en un oxyde inerte vis-à-vis dudit oxyde supraconducteur pour former une couronne intérieure (2), ledit oxyde étant choisi pour assurer autour dudit filament (1) une pression d'oxygène suffisante pour que l'oxygène de l'oxyde supraconducteur y soit maintenu,
   - on constitue un ensemble formé successivement
     . dudit bâtonnet,
     . dudit tube,
     . d'un tube en un matériau peu perméable à l'oxygène destiné à former une première gaine (3),
     . d'un tube en un matériau jouant le rôle de barrière de diffusion vis-à-vis du cuivre de ladite couronne extérieure (5) et destiné à former une deuxième gaine (4)
     . d'un tube de cuivre destiné à former ladite couronne extérieure (5),
   - on effectue des opérations d'étirage et de tréfilage,
   - on réalise le frittage de ladite poudre supraconductrice.

2. Procédé selon la revendication 1, caractérisé par le fait que l'oxyde de ladite couronne intérieure (2) est choisi parmi un oxyde de baryum, l'alumine, un oxyde de plomb, l'oxyde d'argent Ag$_2$O ou Ag$_2$O$_2$, la magnésie, la zircone, la zircone yttriée, l'oxyde de calcium, un oxyde de type Y$_2$BaCuO$_3$, seuls ou en mélanges.

3. Procédé selon l'une des revendications 1 et 2, caractérisé par le fait que le matériau de ladite première gaine (3) est choisi parmi l'aluminium, un alliage de cuivre et d'aluminium, et l'acier inoxydable.

4. Procédé selon l'une des revendications précédentes, caractérisé par le fait que ladite deuxième gaine (4) est en un matériau choisi parmi le niobium, le tantale, le vanadium.

5. Procédé selon la revendication 1 caractérisé par le fait que
   - on réalise un bâtonnet par compactage isostatique de poudre de $YBa_2Cu_3O_{7-y}$, puis un tube par compactage isostatique d'oxyde de baryum ou d'alumine,
   - on constitue ensuite un ensemble formé successivement dudit bâtonnet, dudit tube, d'un tube en aluminium, d'un tube en niobium et d'un tube de cuivre,
   - on effectue les opérations d'étirage et de tréfilage, on réalise le frittage de ladite poudre de $YBa_2Cu_3O_{7-y}$.

6. Procédé de fabrication d'un brin multifilamentaire caractérisé par le fait que l'on empile une pluralité de brins monofilamentaires obtenus par le procédé selon l'une des revendications 1 à 5.

**Claims**

1. A method of manufacturing a superconducting strand having a high critical temperature; comprising a filament (1) of sintered superconducting oxide powder and an outer covering of copper (5), characterized in that
   - a rod is made of said superconducting oxide powder by isostatic compacting in order to become said filament (1),
   - a tube is made of an oxide powder inert with regard to said cuperconducting oxide, by isostatic compacting in order to form an inner covering (2), said oxide being selected in such a manner as to ensure sufficient oxygen pressure around said filament (1) for the oxygen of the superconducting oxide to be maintained therein,
   - a unit is made successively of
     . said rod,
     . said tube,
     . a tube of a material which is poorly permeable to oxygen and intended to constitute a first cladding (3),
     . a tube of a material acting as a diffusion barrier with ragard to the copper of said outer covering (5) and intended to constitute a second cladding (4),
     . a copper tube acting as said outer covering (5),
   - drawing and wire-drawing operations are performed,
   - said superconducting powder is sintered.

2. A method according to claim 1, characterized in that the oxide of said inner covering (2) is selected from: an oxide of barium, alumina, an oxide of lead, $Ag_2O$ or $Ag_2O_2$ silver oxide, magnesia, zirconia, yttrium zirconia, calcium oxide, and an oxide of the type $Y_2BaCuO_3$ on their own or mixed together.

3. A method according to one of claims 1 and 2, characterized in that the material of said first layer of cladding (3) is selected from aluminum, an alloy of copper and aluminum, and stainless steel.

4. A method according to one of the preceding claims, characterized in that said second layer of cladding (4) is made of a material selected from niobium, tantalum, and vanadium.

5. A method according to claim 1, characterized in that
   - a rod is made of $YBa_2Cu_3O_{7-y}$ powder by isostatic compacting, then a tube is made by isostatic compacting of barium or aluminum oxide,
   - an assembly is then built up comprising, in succession, said rod, said tube, a tube of aluminum, a tube of niobium, and a tube of copper,
   - drawing and wire-drawing operations are then performed, and $YBa_2Cu_3O_{7-y}$ powder is then sintered.

6. A method of manufaturing a multifilament strand, characterized in that a plurality of monofilament strands obtained by the method according to one of claims 1 to 5 are stacked together.

**Patentansprüche**

1. Verfahren zur Herstellung einer supraleitenden Verbundader mit hoher kritischer Temperatur, die einen supraleitenden gesinterten Oxidpulverfeden (1) und eine äußere Kupferkrone (5) aufweist, dadurch gekennzeichnet, daß
   - ein Stäbchen durch isostatisches Kompaktieren des supraleitenden Oxidpulvers zur Bildung des Fadens (1) hergestellt wird,
   - ein Rohr durch isostatisches Kompaktieren eines Pulvers und eines Oxids hergestellt ist, das gegenüber dem supraleitenden Oxid inert ist, um eine innere Krone (2) zu bilden, wobei das Oxid ausgewählt wird, um um den Faden (1) einen Sauerstoffdruck zu bewirken, der ausreicht, damit der Sauerstoff des supraleitenden Oxids dort erhalten bleibt,
- eine Einheit gebildet wird, die nacheinander besteht aus
  . dem Stäbchen,
  . dem Rohr,
  . einem Rohr aus einem wenig sauerstoffdurchlässigen Material, das eine erste Hülle (3) bildet,
  . einem Rohr aus einem Material, das die Rolle einer Diffusionsbarriere gegenüber dem Kupfer der äußeren Krone (5) spielt und eine zweite Hülle (4) bildet,
  . einem Kupferrohr, das die äußere Krone (5) bildet,
- eine Streckformung und eine Drahtziehung erfolgen,
- das supraleitende Pulver gesintert wird.

2. Verfahren nach Anspruch 1, dadurch gekennzeichnet, daß das Oxid der inneren Krone (2) ausgewählt wird aus einem Bariumoxid, Aluminiumoxid, einem Bleioxid, Silberoxid $Ag_2O$ oder $Ag_2O_2$, Magnesiumoxid, Zirkonoxid, Yttriumzirkonoxid, Calciumoxid $CaO_2$, einem Oxid der Art $Y_2BaCuO_3$ jeweils alleine oder in Mischungen.

3. Verfahren nach einem der Ansprüche 1 und 2, dadurch gekennzeichnet, daß das Material der ersten Hülle (3) ausgewählt wird aus Aluminium, einer Kupfer-Aluminium-Legierung und rostfreiem Stahl.

4. Verfahren nach einem der vorhergehenden Ansprüche, dadurch gekennzeichnet, daß die zweite Hülle (4) aus einem Material besteht, das aus Niob, Tantal und Vanadium ausgewählt wird.

5. Verfahren nach Anspruch 1, dadurch gekennzeichnet, daß
- durch isostatisches Kompaktieren von supraleitendem Oxidpulver $YBa_2Cu_3O_{7-y}$ ein Stäbchen und dann durch isostatisches Kompaktieren von Bariumoxid oder Aluminiumoxid ein Rohr hergestellt wird,
- dann eine Einheit bestehend nacheinander aus dem Stäbchen und dem genannten Rohr, einem Aluminiumrohr, einem Niobrohr und einem Kupferrohr zusammengefügt wird,
- die Vorgänge der Streckformung und der Drahtziehung erfolgen und das Pulver $YBa_2Cu_3O_{7-y}$ gesintert wird.

6. Herstellungsverfahren für eine Vielfadenader, dadurch gekennzeichnet, daß zahlreiche gemäß dem Verfahren nach einem der Ansprüche 1 bis 5 hergestellten Einfadenadern gestapelt werden.